# EUROPEAN PATENT APPLICATION

(11) **EP 1 100 300 A2**
(43) Date of publication of application: **16.05.2001**
(21) Application number: 00420229.7
(22) Date of filing: 07.11.2000
(51) Int. Cl.: H05K 9/00

(54) **Fabric for electromagnetic wave shielding**

(30) Priority: 10.11.1999 JP 32032199; 29.09.2000 JP 2000300692
(71) Applicant: GUN EI CHEMICAL INDUSTRY CO., LTD., Takasaki-shi, Gunma-ken 370 (JP); Tsukada, Norikazu, Yokohama-shi, Kanagawa-ken (JP); Hamano Gunma Co., Ltd, Takasaki-shi, Gunma-Ken (JP)
(72) Inventor: Yasumatsu, Yasuhiko, c/o Gun Ei Chemical Co., Ltd, Takasaki-shi, Gunma-ken (JP); Iizuka, Toshi, c/o Gun Ei Chemical Co., Ltd, Takasaki-shi, Gunma-ken (JP); Tsukada, Norikazu, Yokohama-shi, Kanagawa-ken (JP); Ogashiwa, Hideo, c/o Hamano Gunma Co., Ltd, Takasaki-shi, Gunma-ken (JP)
(74) Representative: Vuillermoz, Bruno

(57) **Abstract**

Almost none of conventional shielding parts for shielding from electromagnetic waves from electric or electronic equipment are hitherto provided in view of fire retardancy, and development of such shielding parts has been desired. A fabric for electromagnetic wave shielding (10) is provided which comprises fibers which contain at least 15% by weight of phenol resin fibers, wherein an electrically conductive layer is formed on the surface of the fibers, whereby the fabric possesses an electromagnetic wave shielding property, and the fire retardancy and the fire-spread resistance are improved due to excellent fire-retardant properties of the phenol resin fibers.

## Description

### BACKGROUND OF THE INVENTION

### 1. FIELD OF THE INVENTION

The present invention relates to a fabric for electromagnetic wave shielding. In particular, the present invention relates to a fabric for electromagnetic wave shielding which provides excellent fire retardancy.

### 2. DESCRIPTION OF RELATED ART

In home electric appliances such as television sets and in electronic equipment such as computers, facsimile machines, and copying machines, articles made of resins such as plastics are widely used. Casings made of such resins possess almost no electromagnetic wave shielding property in comparison with metallic casings. Incidentally, recently, consideration of the effect of electromagnetic waves on human bodies has been increasing, and various regulations for reducing the field strength of electric or magnetic waves with which human bodies are irradiated have been strengthened. In addition, since some electronic parts are susceptible to the effect of electromagnetic waves from their surroundings, the necessity of securing normal operation of electronic parts has also expanded the utility of electromagnetic wave shielding.

To cope with the above, measures have been hitherto taken; for example, a shielding property, which is the property of preventing electromagnetic waves from radiating outside a casing, is imparted by an electrically conductive coating film formed by applying an electrically conductive coating material on the inner surface of the casing; a portion of a power supply cable or a communication cable which is introduced into a casing, and having a sheath removed therefrom, is covered by a fabric for electromagnetic wave shielding; or electric or electronic parts to be installed in a casing (in particular, a tuner, a power supply transformer, a hard disc drive of a computer, or the like, which radiates electromagnetic waves with high frequencies) are covered by a special metallic casing and are housed therein.

As the above fabric for electromagnetic wave shielding, union fabrics comprising fibrous steel wires or copper wires have been supplied. However, such a fabric has the problems that it does not have sufficient flexibility and thus is not suitable for minute forming, and that it is not easy to cut such a fabric. Therefore, there have been recently supplied articles which are prepared by weaving fibers on the surface of which an electrically conductive layer is formed by electroless plating or by forming such fibers as nonwoven fabrics, or articles in which an electrically conductive layer is formed on the surface of foundation fabrics, such as woven fabrics or nonwoven fabrics comprising one of various fibers, by thermal spraying, coating, electroless plating, or the like. Types of fibers constituting such fabrics for electromagnetic wave shielding are not particularly limited, and various fibers such as synthetic fibers including meta-aramid fibers, acrylic fibers, and polyester fibers, and natural fibers including cotton and wool can be employed. This kind of a fabric for electromagnetic wave shielding can be formed into various shapes, and therefore the fabrics formed in desirable shapes are used everywhere in electric and electronic equipment, and the utility of such fabrics and the demand therefore have been increased.

For example, some types of electric cables for power supply or the like which are introduced and disposed in electric or electronic equipment radiate electromagnetic waves. In order to prevent radiation of electromagnetic waves in particular from the portion from which a shield of the cable is removed to make a connection inside the equipment, the portion is covered by the fabric which is formed into a tape or a sheet. Also for the casings for housing a tuner, a power supply transformer, a hard disc drive of a computer, or the like, it is common to use the above fabric for electromagnetic wave shielding or a sealing material in which the above fabric is fixed to an elastic core material such as rubber or sponge in order to prevent radiation of the electromagnetic waves from the boundaries of a plurality of members which are assembled into the casing or from around a lid or the like which is provided on an opening for working.

Incidentally, with regard to various electric and electronic equipment as described above, standards, regulations, and restrictions have been hitherto stipulated in detail in order to prevent heat from electronic parts or a spark (or an arc) from a defective connection from causing ignition or spread of fire, by which the designing of the equipment are greatly affected. In addition, standards, regulations, and restrictions on the above-described electromagnetic wave shielding properties tended to increase, and have become great constraints on the designing of the equipment. However, almost none of the above-described conventional fabrics for electromagnetic wave shielding in general are hitherto provided in view of fire retardancy (fire resistance or the like), which has been a remote cause that complicates the design of the equipment, and has been a problem.

For example, although techniques of fire-retardant treatment for acrylic fibers, nylon fibers, and the like, which are commonly used as materials for fabric for electromagnetic wave shielding, have been proposed, none of these techniques reliably avoid the spread of fire, and the effects of these techniques are unsatisfactory. In addition, there has been the problem that synthetic fibers on which electroless plating is carried out, which is a common process for providing a fabric for electromagnetic wave shielding with an electrically conductive layer, become flammable even if it has been subjected to fire-retardant treatment.

The present inventors have noted the phenomenon that even if an electrically conductive layer is formed on the surface of thermally meltable synthetic fibers such as acrylic fibers and polyester fibers by electroless plating, the fibers are melted by heat when exposed to flame and burn with the electrically conductive layer on the surface thereof acting as a wick. Even if a fabric is made of synthetic fibers which have been subjected to fire-retardant treatment, the above phenomenon results in spread of fire on the fabric in which an electrically conductive layer is formed on the fibers by electroless plating, when the fabric is exposed to flame, due to combustion of the melted synthetic fibers. Therefore, sufficient fire retardancy cannot be imparted to a fabric for electromagnetic wave shielding by carrying out electroless plating on synthetic fibers which have simply been subjected to fire-retardant treatment. This is also sometimes the case with a fabric in which an electrically conductive layer is formed on the fibers by a process other than electroless plating.

In order to cope with the above problems, one may think of carrying out fire-retardant treatment by a later process using a halogen fire retardant such as chlorine and bromine after plating. Synthetic resin fibers to which a halogen fire retardant is added causes the problem that the disposal operation is difficult since, for example, dioxin is generated by incineration for disposal if the combustion temperature is low. Accordingly, a special way of handling or a special incineration facility is required for disposal, which may increase the cost of disposal, and the above problem of fire retardancy has not yet solved fundamentally.

In view of the above, a fabric for electromagnetic wave shielding may be prepared using inorganic fibers such as glass fibers and carbon fibers. However, although such a fabric may have a sufficient fire retardancy, it is not suitable for detailed forming work, and is unsatisfactory in that the application of the fabric is limited. In addition, there is a problem that such a fabric has a comparatively high cost.

Moreover, the application of a fabric for electromagnetic wave shielding is not limited to electromagnetic wave shielding parts for electric or electronic equipment, and the fabric may be used for clothes, for example, such as an electromagnetic wave shielding apron, or for a material for an electromagnetic wave shielding curtain. However, a fabric for electromagnetic wave shielding prepared using inorganic fibers such as glass fibers and carbon fibers has problems in the texture, the feel, the heat retaining property, or the like, if it is uses as a material for clothes or the like.

Thus, there has been no fabric for electromagnetic wave shielding which satisfies conditions such as flexibility, formability, and cost, in addition to electromagnetic wave shielding property and fire retardancy, and development of such a fabric for electromagnetic wave shielding has been desired.

### BRIEF SUMMARY OF THE INVENTION

The present invention has been achieved in view of the above problems, and the object of the present invention is to provide a fabric for electromagnetic wave shielding which is excellent in the flexibility and the formability and can be produced at a low cost in addition to possessing an electromagnetic wave shielding property and fire retardancy.

In order to solve the above problems, the present invention provides the following solutions (first to third aspects).

A first aspect of the present invention is a fabric for electromagnetic wave shielding comprising fibers which contain at least 15% by weight of phenol resin fibers, wherein an electrically conductive layer is formed on the surface of the fibers, and whereby the fabric possesses an electromagnetic wave shielding property.

A second aspect of the present invention is a fabric for electromagnetic wave shielding as in the first aspect, wherein the electrically conductive layer is formed after a foundation fabric is prepared from the fibers.

A third aspect of the present invention is a fabric for electromagnetic wave shielding as in the first or second aspect, wherein the fibers further contains meta-aramid fibers in addition to the phenol resin fibers.

The fabric for electromagnetic wave shielding according to the present invention possesses excellent fire retardancy since phenol resin fibers are used in preparing the fabric. Phenol resin fibers have extremely high fire retardancy and heat resistance. For example, phenol resin fibers are considered to have excellent fire retardancy, having a limit oxygen index (LOI) of 30 to 35. In electric or electronic equipment in which radiation of electromagnetic waves is prevented using such a fabric for electromagnetic wave shielding, there is no risk that the fabric will catche fire or that fire will spread on the fabric, and therefore, even if heat is generated due to a failure of the electric system, ignition which may cause a fire can be avoided. For example, even if this fabric is exposed to an arc generated due to a failure of a high-voltage transformer or the like, the fabric does not burn or cause the spread of fire, and the electromagnetic wave shielding property can be maintained. Accordingly, since there is no risk of ignition or the spread of fire with this fabric for electromagnetic wave shielding due to its fire retardancy even if it is disposed near a high-voltage equipment, the fabric for electromagnetic wave shielding can be used in places where a conventional fabric for electromagnetic wave shielding could not be used, and therefore the application of the fabric for electromagnetic wave shielding is extended in comparison with a conventional fabric for electromagnetic wave shielding.

Phenol resin fibers possess the following properties: they do not melt or shrink when heated, and generate almost no smoke when burning (a low smoking property); even if the fibers are exposed to flame, they are only carbonized, and the fire does not spread on them (fire-spread resistance); and when carbonizing, the fibers generate little toxic gas, or gas generated has almost no toxicity (a low toxicity property). The above properties of the phenol resin fibers are imparted to the fabric for electromagnetic wave shielding, and even if the fabric is exposed to strong flame, melting and shrinkage of the fabric due to heat are insignificant in comparison with conventional fire-retardant fibers, and the fabric exhibits a lower smoking property, greater fire-spread resistance, and lower toxicity in comparison with a fabric for electromagnetic wave shielding comprising conventional fire-retardant fibers.

That is, the effects of the present invention are as follows:

Since the fabric for electromagnetic wave shielding in the first aspect of the present invention comprises more than one type of fiber which contain at least 15% by weight of phenol resin fibers, wherein an electrically conductive layer is formed on the surface of the fibers, and whereby the fabric possesses an electromagnetic wave shielding property, the fabric possesses not only excellent electromagnetic wave shielding, but also excellent fire retardancy. In particular, since the fibers contain at least 15% by weight of phenol resin fibers, the fabric possesses fire-spread resistance and a self-extinguishing property, and therefore, even if the fabric catches fire, the damage can be minimized since the fire does not spread and only the part near the origin of fire may be burned. Furthermore, since the fabric possesses excellent flexibility, the fabric can be formed into various shapes and is highly versatile since it can be used for various products.

In addition, since this fabric possesses a reliable fire-retardant property even if it contains thermally meltable synthetic fibers, fire-retardant treatment using a halogen fire retardant after formation of the electrically conductive layer can be omitted. Therefore, problems of environmental pollution, such as generation of dioxin when the fabric is incinerated, can be avoided, and the fabric can be easily disposed of by normal measures such as incineration. Since safety during incineration can be ensured using fibers similar to the phenol resin fibers with regard to generation of no toxic gas or an extremely small amount of toxic gas when burning, as fibers to be mixed with the phenol resin fibers, the first aspect of the present invention exhibits the excellent effect that disposal treatment can be carried out at a low cost by a simple process.

The fabric for electromagnetic wave shielding in the second aspect of the present invention exhibits the excellent effect that the fabric surely possesses an excellent electromagnetic wave shielding property and a fire-retardant property since local peeling of the electrically conductive layer, which is formed on the fibers after the foundation fabric is prepared, is rare in comparison with a fabric which is produced by weaving or the like of fibers on which an electrically conductive layer is formed.

The fabric for electromagnetic wave shielding in the third aspect of the present invention obtains improved mechanical properties such as tensile strength since meta-aramid fibers are mixed in the fabric in addition to the phenol resin fibers. Moreover, since the meta-aramid fibers, which do not generate toxic gas when burning, are used, the fabric for electromagnetic wave shielding in the third aspect of the present invention exhibits an excellent effect that a disposal process such as incineration can be carried out safely.

### BRIEF DESCRIPTION OF THE SEVERAL VIEWS OF THE DRAWING

Fig. 1 is a front view showing a test device used for firing tests on the fabric for electromagnetic wave shielding according to the present invention.

Fig. 2 is a perspective view showing an example of fabric for electromagnetic wave shielding according to the present invention which is formed into a tape shape.

Fig. 3 is a perspective view showing an example of fabric for electromagnetic wave shielding according to the present invention which is used as a shield layer of an electric cable.

Fig. 4 is a perspective view showing an example of fabric for electromagnetic wave shielding according to the present invention which is formed into a tube shape.

Fig. 5 is a perspective view showing an electromagnetic wave shielding part in which a fabric for electromagnetic wave shielding according to the present invention is fixed around an elastic core material, and showing another fabric which is provided so as to cover a ventilating opening of a casing of electronic equipment.

Fig. 6 is a perspective view showing an example of a use of the fabric for electromagnetic wave shielding according to the present invention as a material for wallpaper and a curtain.

### DETAILED DESCRIPTION OF THE INVENTION

In the following, embodiments of the fabric for electromagnetic wave shielding according to the present invention will be described.

In the description of the mixing ratio of fibers, "%" represents "% by weight" unless otherwise indicated.

The basis of the fabric for electromagnetic wave shielding according to the present invention is a fabric which is produced by preparing a foundation fabric (a woven fabric or a nonwoven fabric) from at least 15% of phenol resin fibers and another type of fibers, and forming an electrically conductive layer on the foundation fabric (or specifically the fibers which constitute the foundation fabric).

The woven fabric or the nonwoven fabric which forms the above foundation fabric may be either a fabric in which constituent fibers are used in the form of spun yarn or a fabric in which constituent fibers are used as they are without being spun. In addition, the formation of the electrically conductive layer on the phenol resin fibers or the other fibers which constitute the spun yarn may be carried out either before or after spinning.

The material for the phenol resin fibers to be used in the present invention may be a novolak-type phenol resin, a resol-type phenol resin, or a mixture of a novolak-type phenol resin and a resol-type phenol resin.

An example of fibers for which a novolak-type phenol resin is used as a material is novoloid fibers which are produced by melt-spinning an unset thermoplastic novolak-type phenol resin, and thereafter carrying out a setting process (Japanese Examined Patent Application, Second Publication (Kokoku), No. Sho 48-11284). Examples of fibers for which a resol-type phenol resin is used as a material are fibers which are obtained by adding an acid catalyst to a liquid resol-type phenol resin, and carrying out centrifugal spinning of the resin (Japanese Unexamined Patent Application, First Publication (Kokai), No. Sho 59-179811), and fibers which are obtained by a so-called melt blown method, that is, by melting solid resol-type phenol resin, and carrying out tractional spinning of the resin through a spinning nozzle using a heated air flow (Japanese Unexamined Patent Application, First Publication (Kokai), No. Hei 9-132818). The phenol resin fibers thus obtained are constituted by macromolecules having three-dimensional network structure. It is considered that the reason that phenol resin fibers are not liable to be softened or melted, shrunk, and decomposed by heat, that they have excellent fire retardancy, and that they have excellent arc resistance is due to this molecular structure. In particular, novoloid fibers are widely used under the trade name "KYNOL" (trade name of Gun Ei Chemical Industry Co., Ltd.), and are suitably used in the present invention.

As the fibers to be mixed with the phenol resin fibers, fire-retardant fibers are preferable because of their fire retardancy. As the fire-retardant fibers other than phenol resin fibers, fire-retardant acrylic fibers (so-called modacrylic fibers), fire-retardant rayon fibers (FR rayon), fire-retardant polyester fibers (FR polyester), meta-aramid fibers, or the like may be used. Using these types of synthetic fibers, both excellent flexibility and reduction of cost can be satisfied. Glass fibers or carbon fibers may be also used in a proportion within the range in which they do not damage the flexibility. The fire-retardant fibers other than the phenol resin fibers are not limited to one type, and more than one type of fire-retardant fibers other than the phenol resin fibers may be used together.

The method for forming an electrically conductive layer on the surface of the fibers such as phenol resin fibers, which constitute the foundation fabric for the fabric for electromagnetic wave shielding, may be vapor deposition, sputtering, ion plating, thermal spraying, electroplating, electroless plating, coating, spraying, or the like. Electroless plating is suitably employed since the electrically conductive layer can be formed evenly on the surface of the fibers. Accordingly, it is a standard to employ electroless plating for forming the electrically conductive layer on the surface of the fire-retardant fibers, such as phenol resin fibers, which constitute the fabric of the present invention.

The electrically conductive layer formed by electroless plating is mainly copper or nickel. However, since it is difficult to stably form the electrically conductive layer of nickel on the surface of fibers by electroless plating, it is preferable that the formation of the electrically conductive layer of nickel on the surface of fibers by electroless plating be carried out by first forming an electrically conductive layer made of copper by electroless plating, and thereafter forming a nickel layer by electroless plating on the copper layer.

The total thickness, including the thickness of the electrically conductive layer, of the fibers on which the electrically conductive layer is formed, is preferably 10 to 150 denier, more preferably 30 to 75 denier. The thickness of a single yarn is preferably 0.5 to 5 denier. If the thickness is less than 10 denier, the electromagnetic wave shielding property and the strength will not be sufficient. If the thickness exceeds 150 denier, the flexibility of the fabric is degraded, and formation of a curve or the like become difficult. If the thickness of a single yarn is less than 0.5 denier, plating becomes difficult. If the thickness of a single yarn exceeds 5 denier, the flexibility becomes degraded.

An electromagnetic wave consists of an electric field and a magnetic field, and waves associated with the electric field and the magnetic field are propagated orthogonally to each other. Therefore, in general, in a shielding fabric which is a woven fabric, cross points of electrically conductive layers on the surface of fibers are formed since the electrically conductive layers are formed on the surface of fibers which cross each other, and thereby an effective shielding property can be obtained. The aspect ratio of a unit of lattice formed by crossing the fibers is preferably 0.5 to 1.5 in view of the shielding effect. Accordingly, a preferable range of the aspect ratio of a unit of the lattice formed by the fibers in the fabric according to the present invention is also 0.5 to 1.5. The unit of the lattice may be rhombic; however, in view of shielding effects, a square shape is preferable.

The shielding mechanism of the fabric is dependent on the reflecting characteristics of the electric field and the eddycurrent characteristics of the magnetic field, among which the electric field is dependent on the dielectric constant of an electric conductor which is provided on the fibers in the shielding fabric. In addition, even if the fibers on which an electrically conductive layer is formed are not in contact with each other, a certain level of shielding properties can be achieved due to the above characteristics of the electric field.

General properties of the above-mentioned novoloid fibers (trade name: "KYNOL"; manufactured by Gun Ei Chemical Industry Co., Ltd.) are as follows: specific gravity: 1.28; diameter of fiber: 14 to 20 µm (or 2 to 4 d; "d" denotes "denier" here and hereinafter); tensile strength: 1.3 to 1.8 g/d; tensile modulus: 300 to 400 kg/mm²; elongation: 30 to 50%; LOI (limit oxygen index): 30 to 35; no thermal plasticity ("thermal plasticity" indicates "thermal meltability" and "thermal shrinkage" here and hereinafter); almost no toxicity and smoke when burning; highest possible temperature for use: 150°C in air, 250°C without air. In addition, the novoloid fibers have excellent chemical resistance against organic solvents and acids.

An example of fire-retardant acrylic fiber (hereinafter occasionally referred to as a "modacrylic fiber") is a yarn which is spun out of a copolymer of acrylonitrile and vinyl chloride. Since such a yarn has a structure which is not readily decomposed by heat, it possesses fire retardancy. For example, properties related to fire retardancy, heat resistance, and the like, of Protex-M type (2-denier type) fibers of "KANEKALON" manufactured by Kaneka Corp., which are used in the firing test below, are as follows: specific gravity: 1.28; diameter of fiber: LOI (limit oxygen index): 33.5; thermal shrinkage is exhibited (approximately 10% at 180°C); smoke is slightly generated when burning.

An example of a fire-retardant rayon fiber is a polynosic fiber which is obtained by spinning a yarn while adding a fire retardant such as a phosphorus compound (phosphorus-nitrogen compound, for example) by kneading. It is known that such a polynosic fiber exhibits fire resistance and fire retardancy by a fire-preventive mechanism of the dehydrating carbonation promotion type. That is, when the fiber is brought into contact with a flame, phosphorus in the fire retardant forms polyphosphoric acid, and by the dehydration function of the polyphosphoric acid, the thermally decomposed polynosic fiber is carbonized before flammable gas is generated. The LOI (limit oxygen index) of "TUFBAN" manufactured by Toyobo Co., Ltd., which is used in the firing test below, is 30 to 32.

An example of fire-retardant polyester fiber is a polyester fiber in which a phosphorus compound is copolymerized as a fire retardant. "HEIM" manufactured by Toyobo Co., Ltd., which is used in the firing test below, exhibits dimensional stability and chemical resistance which are nearly equivalent to those of a polyester, and has the following properties: thermal shrinkage is only slightly exhibited; LOI (limit oxygen index) is 28 to 30; thermal plasticity and thermal meltability are exhibited; smoke is generated when burning.

An example of meta-aramid fiber is a wholly aromatic polyamide fiber of meta-type which has a poly(m-phenyleneisophthalamide) which is produced by reacting m-phenylenediamine and isophthaloyl chloride. The wholly aromatic polyamide fiber has a structure which is not readily decomposed by heat, and exhibits fire retardancy. "CONEX" manufactured by Teijin Ltd. has the following properties: LOI (limit oxygen index): 26 to 30; no thermal plasticity (no thermal meltability; dry heat shrinkage of 1% or less at up to 250°C; flash point: 615°C; no ignition by heating at 700°C; a self-extinguishing property is exhibited.

According to firing tests, it is known that a phenol resin fiber is superior to the above-described acrylic fiber, rayon fiber, and polyester fiber in ignition resistance (TG/DTA), fire-spread resistance (UL Standard; JIS K 6911), generation of little gas when burning (the NBS test, or the like, standardized by Airbus Industries), self-extinguishing property (JIS K 7201), and thermal melting resistance (JIS K 7121). Thus fire does not easily spread on phenol resin fibers, and even if phenol resin fibers catch fire, they exhibit a self-extinguishing property. In addition, even if phenol resin fibers on the surface of which an electrically conductive layer is formed by electroless plating are exposed to a flame, the phenol resin fibers do not burn with the electrically conductive layer on the surface acting as a wick since the phenol resin fibers inside the electrically conductive layer are simply carbonized and are not thermally melted.

In addition, since a phenol resin fiber is inferior to other fibers such as the above-mentioned acrylic fiber and rayon fiber in tensile strength or the like, use of the other type of fibers mixed with the phenol resin fibers must be considered where a high strength of the fiber is required. In such a case, it is adequate that the upper limit of the phenol resin fiber to be mixed is approximately 80%. In such a case, various fibers may be used with the phenol resin fibers. However, in order to have the fibers obtain sufficient tensile strength and flexibility, it is preferable to employ the above-described acrylic fiber, rayon fiber, polyester fiber, meta-aramid fiber, or the like, all of which are fire retardant. In order to achieve particularly excellent fire retardancy, it is more preferable that meta-aramid fibers, for example, be used, which do not thermally melt and which are decomposed and carbonized when exposed to a flame. If the fabric is installed inside the casing of electric equipment, it is often the case that strength is not required. In such a case, it is adequate that the proportion of the phenol resin fibers to be mixed is 80% or higher so as to make best use of the properties of the phenol resin fibers.

### Electroless Plating

Next, a process for electroless plating is described. "Rinsing with water" is carried out between steps.

(1) Degreasing step: Dirt adhering to the surface of the foundation fabric is removed to increase the wettability of the material.

(2) Step in which a conditioner is applied: Polarity is imparted to the surface of the foundation fabric so as to increase adhesion of a catalyst in the subsequent step.

(Rinsing with water is carried out.)

(3) Step for preparing a catalyst: The foundation fabric is immersed into a solution of a metallic catalyst (such as a colloidal solution of stannous chloride or palladium chloride), and a small amount of hydrochloric acid, potassium chloride, sodium chloride, or the like is added. Instead of palladium, gold, silver, copper, or the like may be used as the catalyst.

In the step for preparing the catalyst, any method can be employed as long as the catalyst (metal) can be adsorbed on the surface of the foundation fabric and the formation of a stable electrically conductive layer in the later step is ensured by the method; for example, a method in which an organic metal such as an organic palladium is used can be employed.

(Rinsing with water is carried out.)

(4) Promoting step: The foundation fabric is immersed in an aqueous solution of sulfuric acid, hydrochloric acid, hydrofluoroboric acid, or the like, so as to deposit the metal as a catalyst, adsorbed in the above step for preparing a catalyst, on the surface of the foundation fabric.

(Rinsing with water is carried out.)

(5) Electroless plating step: The foundation fabric is immersed in a vat dye solution obtained by mixing a metal salt, such as copper sulfate and copper chloride, a chelating agent, such as EDTA (ethylenediaminetetraacetic acid) and Rochell salt, and a reducing agent, such as formalin, so as to deposit the metal in the above metal salt (if the metal salt is copper sulfate or copper chloride, the metal deposited is copper) on the surface of the foundation fabric to form an electrically conductive layer having a thickness of about 0.5 to 4 um. Accordingly, electric conductivity and electromagnetic wave shielding are imparted to the foundation fabric.

As the metal salt, electroless nickel or electroless silver may also be used; however, copper is superior in view of the shielding effect and the cost.

(Rinsing with water is carried out.)

(6) Rust-proofing step: Rust-proofing is carried out when necessary. For example, although electroless copper has an excellent shielding effect, since it is susceptible to corrosion, it is suitable that a surface metallic layer formed from electroless nickel or electroless tin by electroless plating having a thickness of about 0.25 µm be formed on the surface of the electrically conductive layer (metallic copper) for rust-proofing.

In addition, application of organic rust-proofing agent on the surface of the electrically conductive layer is also effective. As the organic rust-proofing agent, benzotriazole, benzimidazole, or the like may be used. However, in view of reduction of the amount of toxic gas generated when the fabric is burning, the above-described formation of a surface metallic layer is advantageous.

The foundation fabric which has undergone electroless plating is sufficiently washed with ambient water and hot water so that metal salts and salts of chlorine or the like do not remain.

Tables 1 and 2 show the results of firing tests on the fabrics according to the present invention.

In Tables 1 and 2, each of Examples 1, 2, and 3, and Comparative Examples K and C is a fabric in which a foundation fabric (woven fabric) subjected to electroless plating of copper is provided with an electrically conductive layer on the surface of fibers which constitute the foundation fabric. The difference between Examples 1, 2, and 3, and Comparative Examples K and C is only in the type of fibers which constitute the foundation fabric, and there is no difference in the conditions of the electroless plating or the like. Each of Comparative Examples A and B is a specimen (woven fabric) which consists of fire-retardant fibers alone.

As phenol resin fibers, the above-mentioned "KYNOL" was used. As fire-retardant acrylic fibers, the above-mentioned Protex-M type (2-denier type) fibers of "KANEKALON" were used. As fire-retardant polyester fibers, the above-mentioned "HEIM" was used. As meta-aramid fibers, the above-mentioned "CONEX" was used.

The electroless plating for Examples 1, 2, and 3, and Comparative Examples K and C was carried out in accordance with the above-described "electroless plating step". In the step for preparing a catalyst, a mixed catalyst of tin and palladium (a colloidal solution of 4 to 12 g/l of stannous chloride and 30 to 150 mg/l of palladium chloride) was used. In the promoting step, a 10% sulfuric acid was used. In the electroless plating step, copper sulfate as a metal salt, EDTA as a chelating agent, and formalin as a reducing agent were used to form an electrically conductive layer composed of metallic copper on the surface of the foundation fabric. The rust-proofing step was not carried out.

In Example 1, a woven fabric, consisting of union yarn of 70% phenol resin fibers (the above-mentioned "KYNOL") and 30% meta-aramid fibers, on which an electrically conductive layer was formed by electroless plating, was used.

In Example 2, a woven fabric, consisting of union yarn of 20% phenol resin fibers, 45% fire-retardant acrylic fibers, 10% fire-retardant rayon fibers, and 25% fire-retardant polyester fibers, on which an electrically conductive layer was formed by electroless plating, was used.

In Example 3, a woven fabric consisting of 100% phenol resin fibers (the above-mentioned "KYNOL"), on which an electrically conductive layer was formed by electroless plating, was used.

In Comparative Example K, a woven fabric, consisting of union yarn of 10% phenol resin fibers, 55% fire-retardant acrylic fibers, 10% fire-retardant rayon fibers, and 25% fire-retardant polyester fibers, on which an electrically conductive layer was formed by electroless plating, was used.

In Comparative Example A ("A" in Tables 1 and 2), a woven fabric consisting of 100% polyester fibers was used.

In Comparative Example B ("B" in Tables 1 and 2), a woven fabric consisting of 100% modacrylic fibers was used.

In Comparative Example C ("C" in Tables 1 and 2), a woven fabric consisting of 100% polyester fibers, on which an electrically conductive layer was formed by electroless plating, was used.

Table 1 shows the results of firing tests carried out on the specimens of fabrics of Examples 1, 2, and 3, and Comparative Examples K, A, B, and C in accordance with the UL standard (class V-0).

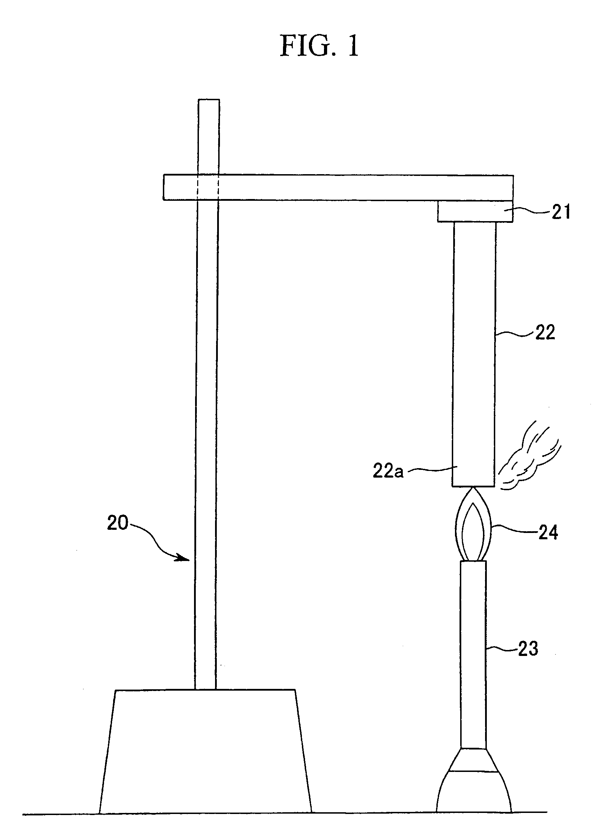

Fig. 1 shows a test device for the above-described firing tests. With the test device, a specimen 22 shaped in a band of predetermined dimensions supported in a manner such that it is suspended by fixing it detachably to a clamp 21 at the upper part of a stand 20, and that the lower end 22a of the specimen 22 can be exposed to (or brought into contact with) flame 24 of a burner (gas burner) 23 placed below the lower end of the specimen for a certain time. Five pieces of specimen 22 were prepared for each of examples 1, 2, and 3, and Comparative Examples K, A, B, and C.

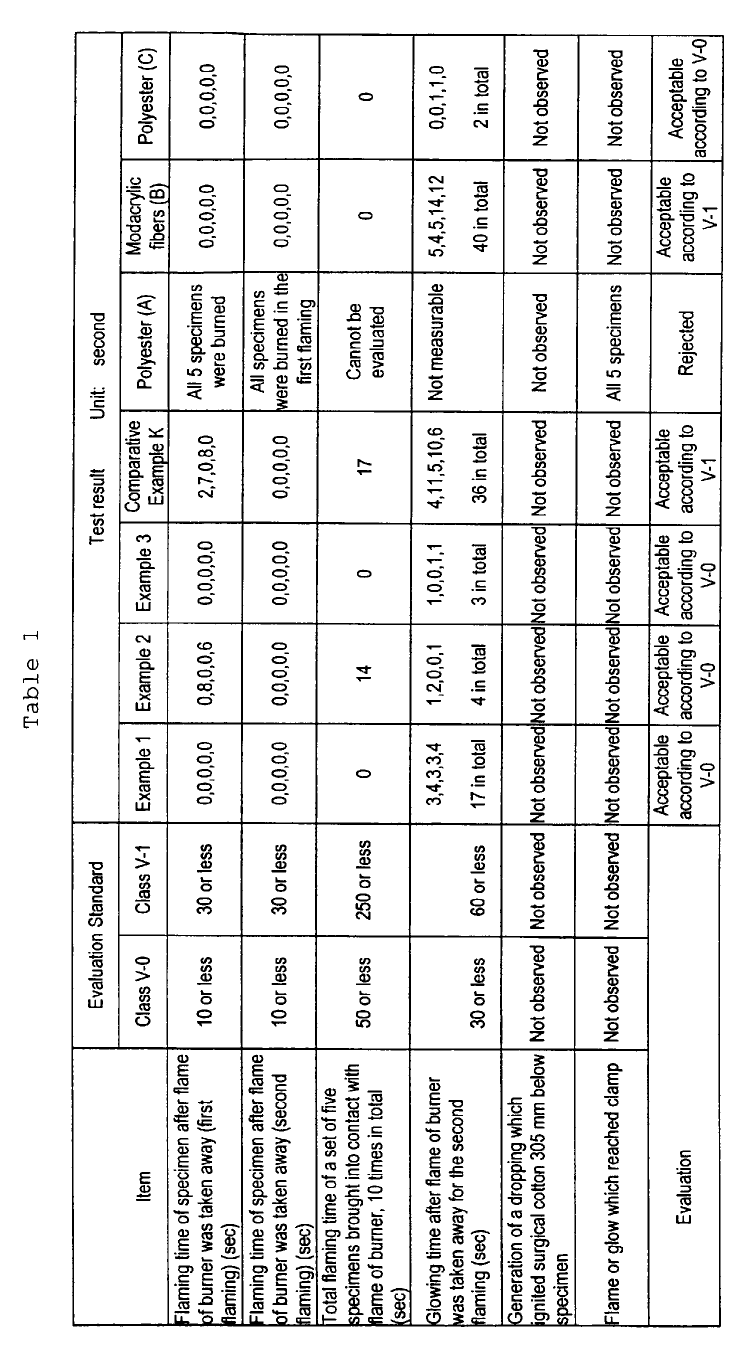

In Table 1, where five numbers are in a cell, those numbers express measured data (unit: second; obtained for the five specimens).

The flaming time of the specimen after the flame of the burner was removed was evaluated with respect to the total of five specimens, measured two times for each specimen, in each example, and was 14 seconds in Example 2 and 17 seconds in Example K. The flaming time in Comparative Example A could not be measured since all specimens were burned. The flaming time in Examples 1 and 3 and Comparative Example B was 0. The glowing time of the specimen after the flame of burner was taken away for the second time was 17 seconds in Example 1, 4 seconds in Example 2, and 3 seconds in Example 3, which are shorter than 36 seconds in Comparative Example K and 40 seconds in Comparative Example B, but slightly longer than 2 seconds in Comparative Example C.

As shown in the last row of Table 1, it can be observed from the results of the tests that the specimens of Examples 1, 2, and 3 were all acceptable according to the V-0 class standard, and the specimen of Comparative Example C was acceptable according to the V-1 class standard. The specimens of Comparative Examples K and B were acceptable according to the V-0 class standard, and the specimen of Comparative Example C was acceptable according to the V-0 class standard.

Table 2 also shows the results of the firing test according to the UL standard; however, in Table 2, the length of a non-carbonized portion of the specimen and the length of shrinkage of the specimen are shown (L0-L1; L0 is the original length. L1 is the length of the specimen after the test).

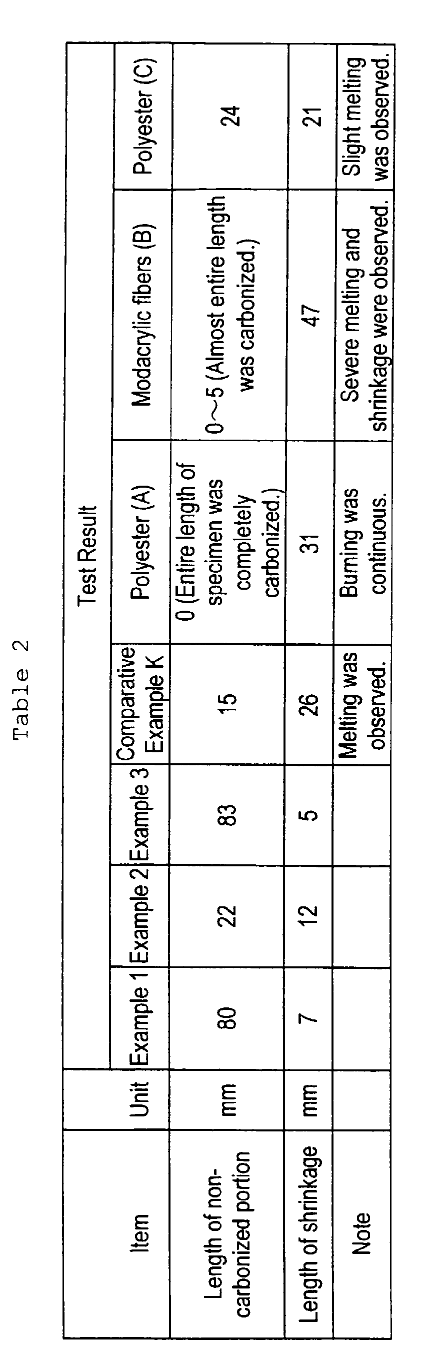

In Table 2, the specimens of Examples 1, 2, and 3 all exhibited minor shrinkage in comparison with Comparative Examples K, A, B, and C, and thus it can be seen that the specimens of Examples 1, 2, and 3 are not easily shrunk by heat. The length of shrinkage in Example 2 was a quarter of that in Comparative Example B, and the length of shrinkage in Example 1 was a seventh of that in Comparative Example; the characteristics of these Examples were remarkable. The length of shrinkage in Example 3 was even smaller, and thus the specimen of Example 3 has excellent characteristics. The length of a non-carbonized portion was 80 mm in Example 1 and 83 mm in Example 3; carbonization of the specimens of these Examples was minor. The length of a non-carbonized portion the specimen in Example 2 was 22 mm. The specimen of Example 2 exhibited a sufficient property in comparison with the specimens of Comparative Examples A and B, which were carbonized almost over the entire length and left almost no non-carbonized portion. However, the length of the non-carbonized portion of the specimen in Example 2 was smaller than that of Comparative Example C. It is considered that in Example 2, the thermally meltable fire-retardant acrylic fibers and fire-retardant polyester fibers, which were mixed with the phenol resin fibers, were melted by heat, and burned with the electrically conductive layer on the phenol resin fibers acting as a wick. In contrast, it is considered that the higher mixing ratio of the phenol resin fibers used contributed to the characteristics of the specimens of Examples 1 and 3. In Example 1, the characteristic of the meta-aramid fibers, that they are not melted by heat even when exposed to flame but are decomposed and carbonized, contributed to the results of the test.

According to these results, it can be observed that the specimens of Examples 1, 2, and 3 are superior to those of Comparative Examples A, B, and C in terms of the fire resistance and the thermal stability (small shrinkage by heat) In addition, it was found that the specimen of Example 1 is superior to that of Example 2, and the specimen of Example 3 is superior to that of Example 1 in the fire resistance and the thermal stability (small shrinkage by heat).

The length of the non-carbonized portion of the specimen in Comparative Example K was shorter than those of Examples of 1, 2, and 3 and Comparative Example C. In addition, the length of shrinkage of the specimen of Comparative Example K was very large in comparison with those of Examples 1, 2, and 3, and larger than that of Comparative Example C, although it was smaller than those of Comparative Examples A and B. It is considered that the reason why the length of the non-carbonized portion of the specimen of Comparative Example K was smaller than those of Examples 1, 2, and 3, was because the mixing ratio of the phenol resin fibers used in Comparative Example K was about half of that in Example 2, and therefore, the mixing ratio of the phenol resin fibers used in Comparative Example K was too small to exert sufficient fire resistance. In addition, it is considered that the reason why the length of shrinkage of the specimen in Comparative Example K was larger than those of Examples 1, 2, and 3 was because the mixing ratio of the thermally meltable fire-retardant acrylic fibers used was high in the specimen of Comparative Example K, although the mixing ratio of the phenol resin fibers used therein was low.

From the results of the tests shown in Tables 1 and 2, it can been seen that when the mixing ratio of the phenol resin fibers used is 20% or higher, fire-retardant property meeting the V-0 class of the UL standard can be obtained, and the fire-retardant property can be greatly improved in comparison with Comparative Example K, according to which the mixing ratio of the phenol resin fibers was low, and in comparison with Comparative Examples A, B, and C, in which the specimens do not contain phenol resin fibers. In addition, when the mixing ratio of the phenol resin fibers used is 20% or higher, even if the fibers used besides the phenol resin fibers are thermally meltable, the fire-retardant property which is much better than that of the specimen in Comparative Examples K, A, B, and C can be obtained.

According to the inspection by the present inventors, in the fabric of the present invention, even if the mixing ratio of the phenol resin fibers is slightly less than 20%, an excellent fire-retardant property can be obtained, and the ratio of about 15% is considered to be the lower limit for obtaining the fire-retardant property meeting the V-0 class of the UL standard. Accordingly, in order to obtain the fire-retardant property meeting the V-0 class of the UL standard, the mixing ratio of the phenol resin fibers of 15% or higher is preferable, and in order to ensure the fire-retardant property, the mixing ratio of the phenol resin fibers of 20% or higher is preferable. In addition, the fibers used other than the phenol resin fibers are preferably ones which are not melted by heat, such as the above-described meta-aramid fibers Furthermore, the fibers used other than the phenol resin fibers are preferably ones which are excellent in mechanical properties such as tensile strength and flexibility; in this regard, the above-described meta-aramid fibers can be also preferably used. According to the present invention, since an excellent fire-retardant property can be obtained by preventing melted fibers from burning with the electrically conductive layer acting as a wick, the effects of the present invention can be obtained without regard to the type of the metal forming the electrically conductive layer or the method for forming the electrically conductive layer.

Furthermore, since the fabric according to the present invention can possess an excellent fire-retardant property even without a treatment using a halogen fire retardant after electroless plating, the problem of environmental pollution during disposal is solved. In particular, using fibers which generate a gas having little toxicity when burning as fibers other than the phenol resin fibers, a simple disposal such as normal incineration can be employed. In this regard, meta-aramid fibers, whose toxicity is extremely low when burning, can be also preferably used.

Table 3 shows the test results with regard to gases generated by burning the specimens of Examples 1, 2, and 3, and Comparative Examples A, B, and C.

The test method employed here is the NBS test according to the standard of Airbus Industries. Here, concentrations (in ppm) of HCN (cyanide gas), CO (carbon monoxide), NO and NO (nitrogen monoxide and nitrogen dioxide), SO₂ (sulfite gas), HC1 (hydrogen chloride gas), and HF (hydrogen fluoride gas) as toxic gases generated by burning were particularly measured. In the column of "Airbus standard" in Table 3, the symbol "<" represents "less than", and if the concentrations of the generated gases measured by the test are less than the values on the right sides of the symbol "<", the specimen is determined to be "acceptable".

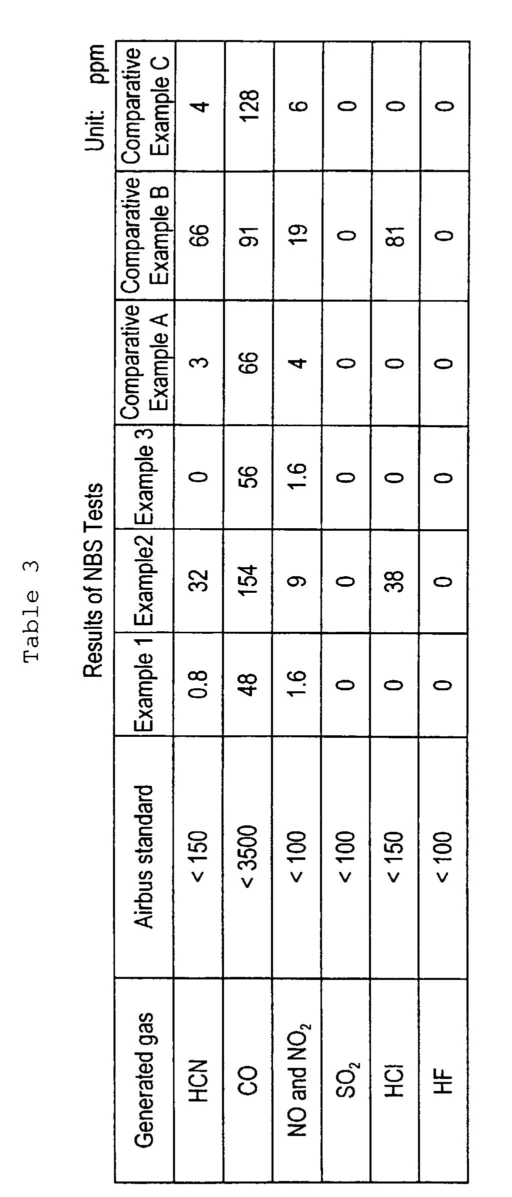

In Table 3, by comparing Examples 1, 2, and 3, it is clear that the amount of gases generated from the specimens of Examples 1 and 3 was extremely small, since with respect to the specimens of Examples 1 and 3, no SO₂, HC1 and HF were detected, and the amounts of HCN, CO, NO, and NO₂ detected (detected concentrations in ppm) are also very small in comparison with those of Example 2 and Comparative Examples A, B, and C (except for the comparison of the CO value with Comparative Example A, the other values were about a half or much less than a half of those detected with respect to the specimens of Example 2 and Comparative Examples A, B, and C). The specimen of Example 2 generated a slightly larger amount of gases such as CO in comparison with those of Comparative Examples A, B, and C. However, all of the specimens of Examples 1, 2, and 3 passed the standard of Airbus Industries by a great margin, and exhibited superior low toxicity generating a small amount of toxic gases. The specimens of Examples 1, 2, and 3 possessed an excellent fire-retardant property and generated a small amount of toxic gases when burning; these specimens can be used as parts providing an excellent electromagnetic wave shielding property and safety (fire-retardancy and low toxicity).

In addition, in the comparison between Examples 1, 2, and 3, the specimens of Examples 1 and 3, which do not contain fire-retardant acrylic fibers, fire-retardant rayon fibers, and fire-retardant polyester fibers, and which contain the phenol resin fibers in lower mixing ratios in comparison with the specimen of Example 2, apparently generate little toxic gas and are superior in low toxicity to that of Example 2. That is, in view of the restriction of the amount of toxic gases generated, it is preferable that a fabric in which the mixing ratios of fire-retardant acrylic fibers, fire-retardant rayon fibers, and fire-retardant polyester fibers are low and the mixing ratios of phenol resin fibers and meta-aramid fibers are high be used. In addition, in the case where the fabric is used as an electromagnetic wave shielding part inside electric or electronic equipment, arc resistance against electric arc generated inside electric or electronic equipment is also required; in this regard, it is more preferable that a fabric in which the mixing ratio of phenol resin fibers is high be used.

The above results show that the fabric for electromagnetic wave shielding according to the present invention functions as an excellent shielding material and as an excellent fire-retardant material, when used as an electromagnetic wave shielding part inside electric or electronic equipment. In addition, since the fabric possesses an excellent fire-retardant property, there is no risk that the fabric will catch fire even if the fabric is installed near a heating unit or a high-voltage device, and the freedom of designing interior of electric or electronic equipment can be increased. Furthermore, the fabric can exert excellent effects when the fabric is used for objects other than electromagnetic wave shielding parts inside electric or electronic equipment, such as a curtain, wallpaper, and an apron which are for electromagnetic wave shielding. Since this fabric is also excellent in flexibility, it can be used in various products. For example, when the fabric is used for an electromagnetic wave shielding part inside electric or electronic equipment, it can be easily applied to a desired position by appropriately warping or bending it.

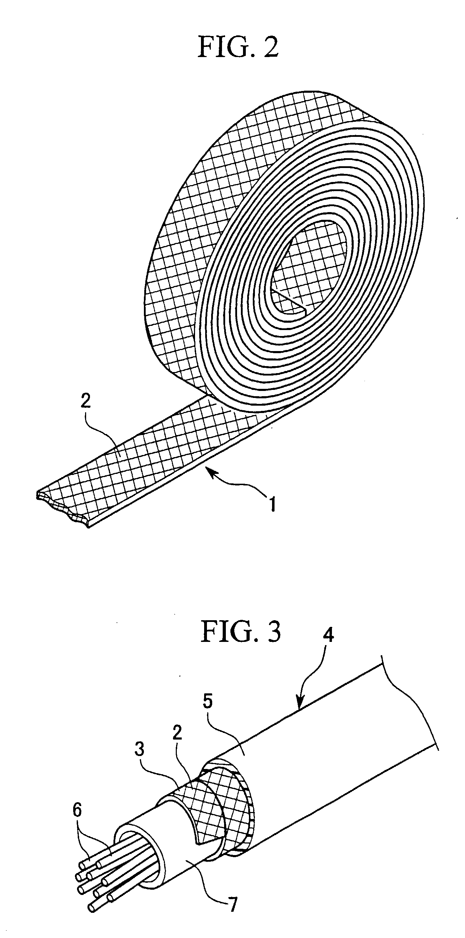

Figs. 2 to 6 show specific examples of application of a fabric for electromagnetic wave shielding according to the present invention.

Fig. 2 shows a tape 1 which consists of a fabric for electromagnetic wave shielding according to the present invention. Basically fibers 2 which constitute the tape 1 are formed into a foundation fabric by union weaving, and thereafter an electrically conductive layer is formed by electroless plating or the like.

In Fig. 3, the fabric for electromagnetic wave shielding 3 is housed inside sheathing 5 of an electric cable 4. This electric cable 4 has a structure in which a shielding layer consisting of the fabric for electromagnetic wave shielding 3 is placed outside an insulating tube 7 which covers the conductive wire 6, and the sheathing 5 covers the outside of the shielding layer. In Fig. 3, although the fabric for electromagnetic wave shielding 3 is in the tape shape, the shape of the fabric is not limited to this shape, and may be in a tube shape.

It is easy to shield against radiation of electromagnetic waves from the conductive wire 6, which is exposed at the end of the electric cable 4, by winding the tape 1 shown in Fig. 2 around the conductive wire 6.

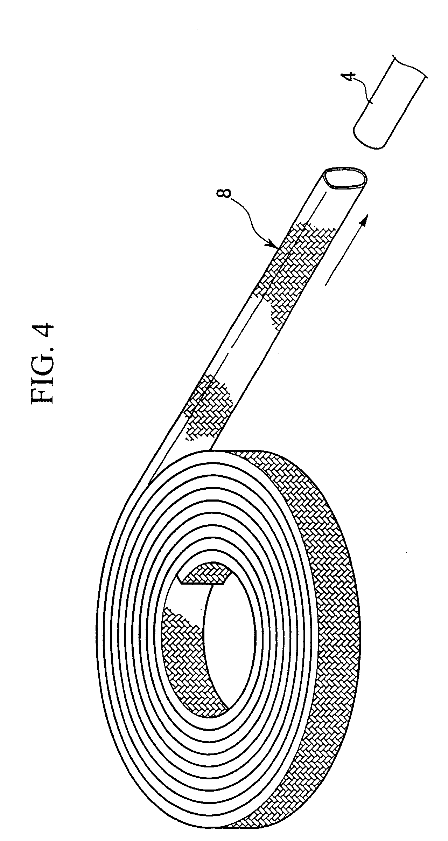

Fig. 4 shows a fabric for electromagnetic wave shielding according to the present invention, which is formed into a tube 8. This tube 8 is suitable for housing the electric cable 4 or conductive wire 6 exposed at the end of the electric cable 4 (see Fig. 3).

Each of the tape 1, the fabric for electromagnetic wave shielding 3, and the tube 8 has excellent flexibility, and are excellent in easy applicability to places where warping or bending is required. In addition, for example, electrically conductive wires such as copper wires can be suitably woven in the tape 1 or the tube 8 so as to maintain the warped or bent shape.

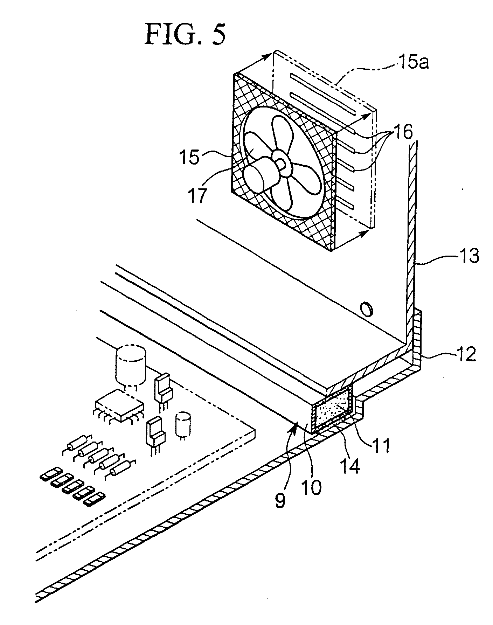

An electromagnetic wave shielding part 9 in Fig. 5 is formed by fixing a fabric for electromagnetic wave shielding 10 to the surface of a core material 11 which is composed of an elastic material having fire retardancy (for example, a urethane foam which has been subjected to a fire-retardant treatment) using an adhesive agent. The electromagnetic wave shielding part 9 can be placed over a junction, or the like, of separated parts 12 and 13 which constitute the casing of electronic equipment. In Fig. 5, the electromagnetic wave shielding part 9 can be adheres easily to a desired position of the casing or the like by an adhesive tape 14 which is fixed to the side of the electromagnetic wave shielding part 9. In addition, the structure for fixing the electromagnetic wave shielding part 9 to a desired position is not limited to the adhesive tape 14, and a structure such that the electromagnetic wave shielding part 9 is inserted into or engaged with a groove formed in the casing or the like may of course be employed. Since the electromagnetic wave shielding part 9 has excellent flexibility, it can be easily warped or bent.

The fabric for electromagnetic wave shielding indicated by numeral 15 in Fig. 5 is provided in such a manner that it covers a ventilating opening 16 in the casing (or the separated part 13 in Fig. 5) of the electronic equipment (the state in which the fabric is provided is shown by imaginary lines). The ventilating opening 16 is an opening for taking the air inside the casing or for discharging the air. In Fig. 5, intake or discharge of the air is forcibly carried out by rotational driving of a fan 17. As the above-described fabric 15, one which is formed to have low density of fibers so as to have excellent permeability, can be used, and thereby the permeability of the ventilating opening 16 can be ensured even when the ventilating opening 16 is closed by the fabric 15.

For a casing of electronic equipment, it is common to provide shielding against electromagnetic wave radiation to the outside by forming the casing itself from an electric conductor or by forming an electrically conductive layer on the inner surface of the casing by electroplating, coating, or the like. However, even in the case where a ventilating opening 16 as shown in Fig. 5 is provided, the installation of the fabric 15 can prevent leakage of electromagnetic waves from the ventilating opening 16, and the electromagnetic wave shielding performance of the casing as a whole can be ensured. In addition, the opening portion formed in the casing of the electronic equipment is not limited to the above-described ventilating opening 16, and it can be, for example, a place where a speaker is installed. A fabric for electromagnetic wave shielding which has a high density of fibers may be used for covering an opening which does not need to be permeable, such as a place where a speaker is installed,

Although Fig. 5 exemplifies a structure in which the inner side of the ventilating opening 16, which is provided in the casing, is covered by the fabric 15, the structure is not limited to this, and the outer side of various openings such as the ventilating opening 16 may be covered by the fabric of the present invention.

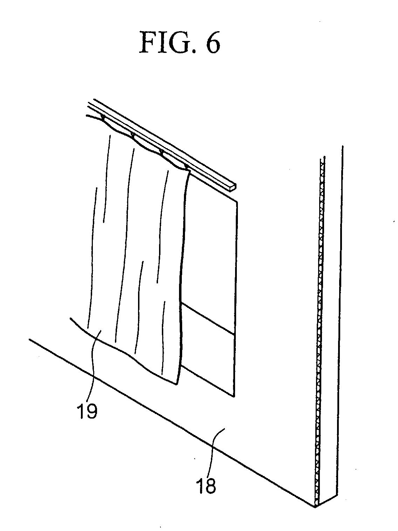

Fig. 6 shows wallpaper 18 and a curtain 19, in which the fabric for electromagnetic wave shielding according to the present invention is used as a material. For example, if all walls and openings, such as windows and entrances, of a room in a building are covered by the above-mentioned wallpaper 18 and curtains 19, shielding from the entire room can be easily achieved. Mutually, radiation of electromagnetic waves from electronic equipment inside the room to the outside of the room can be prevented, and therefore, inconvenience such as the electronic equipment in an adjacent room being affected or privacy being invaded by having electromagnetic waves intercepted can be prevented. On the other hand, inconvenience such as the electronic equipment in the room being affected by electromagnetic waves from the outside of the room can be also prevented.

Since a fine appearance is required for the wallpaper 18 and the curtain 19, a material which gives a fine appearance as an electrically conductive layer formed on the fabric for electromagnetic wave shielding may be used, or the electrically conductive layer may be colored. A treatment which makes the coloring of the surface of the electrically conductive layer easy may also be carried out. However, it is needless to say that a dye for coloring or treatment for making coloring easy should not damage the fire-retardant property of the fabric for electromagnetic wave shielding, which is the material for the wallpaper 18 or the curtain 19.

Since all of the fabrics for electromagnetic wave shielding and the articles made therefrom which are shown in Figs. 2 to 6 are excellent in flexibility, they can be freely warped and bent. In addition, since these fabrics or the like for electromagnetic wave shielding are excellent in the fire-spread resistance and the self-extinguishing property as well as in electromagnetic wave shielding properties and the fire-retardancy, even if ignition of electric or electronic equipment or an electric arc due to an incomplete connection occurs inside the equipment, the spread of fire can be prevented, and the damage can be minimized. Furthermore, since the fabric for electromagnetic wave shielding made using fibers having a low smoking property and a low toxicity, such as phenol resin fibers and meta-aramid fibers, or an article made from such a fabric does not smoke or generate a toxic gas even if it is partially burned, there is no problem such as the smoke or the toxic gas obstructing a person escaping to the outside of a room even when an inner part of the electric or electronic equipment is ignited or burned in a small room, and thus safety can be improved.

Since the phenol resin fibers have excellent chemical resistance, even if the phenol resin fibers are in contact with chemicals or the like used for various parts in the electric or electronic equipment, it does not affect the fire retardancy of the phenol resin fibers. Accordingly, even if the fabric is exposed to leakage from a battery or an electrically insulating coating material, the fabric does not change in quality and can maintain the excellent fire retardancy for a long time. Also in view of the above low smoking property, low toxicity, and chemical resistance, the above-described fabric in which both the phenol resin fibers and the meta-aramid fibers are used is superior.

In the present invention, it is possible to use a woven fabric or a nonwoven fabric in which 15% or higher (mixing ratio with regard to fiber portions without taking the electrically conductive layer into account) of phenol resin fibers on the surface of which an electrically conductive layer is formed (hereinafter referred to as "conductive phenol resin fibers") is mixed. Such a constitution allows easy formation of a woven fabric or a nonwoven fabric by mixing fibers on which an electrically conductive layer is not formed (in a small amount such that the fire-retardant property is not degraded) with fibers on which an electrically conductive layer is formed. For example, in the above-described curtain, wallpaper, or apron, fibers on which an electrically conductive layer is not formed can be used for the purpose of maintaining the coloring property or preventing electric shock.

However, in view of the fact that the spinning of the fibers on which the electrically conductive layer is formed and the weaving of such fibers into a woven fabric require machines which are different from those used in spinning or weaving of normal fibers or require special settings of conventional machines, and in view of the possibility that the electrically conductive layer may be peeled off when spinning or forming the fabric by weaving thereby reducing the shielding performance of the fabric, the electrically conductive layer is basically formed after the formation of the foundation fabric. Such a constitution is advantageous since the spinning and the weaving can be carried out using normal machines. In addition, it is also advantageous in that there is no risk that the electrically conductive layer is partially peeled off during formation of the fabric.

## Claims

1. A fabric for electromagnetic wave shielding (3, 10, 15) comprising fibers (2) which contain at least 15% by weight of phenol resin fibers, wherein an electrically conductive layer is formed on the surface of the fibers (2), whereby the fabric possesses an electromagnetic wave shielding property.

2. A fabric for electromagnetic wave shielding (3, 10, 15) according to claim 1, wherein the electrically conductive layer is formed after a foundation fabric is prepared from the fibers (2).

3. A fabric for electromagnetic wave shielding (3, 10, 15) according to claim 1, wherein the fibers (2) further contain meta-aramid fibers in addition to the phenol resin fibers.

4. A fabric for electromagnetic wave shielding (3, 10, 15) according to claim 2, wherein the fibers (2) further contain meta-aramid fibers in addition to the phenol resin fibers.
